Europäisches Patentamt

European Patent Office

Office européen des brevets

(11) Publication number: **0 198 194**
**B1**

# EUROPEAN PATENT SPECIFICATION

(45) Date of publication of patent specification: **14.06.89**

(21) Application number: **86102790.2**

(22) Date of filing: **04.03.86**

(51) Int. Cl.⁴: **H 01 L 23/48,** H 01 L 23/36,
H 01 L 23/54

(54) Packaged semiconductor chip.

(30) Priority: **18.04.85 US 724736**

(43) Date of publication of application:
**22.10.86 Bulletin 86/43**

(45) Publication of the grant of the patent:
**14.06.89 Bulletin 89/24**

(84) Designated Contracting States:
**DE FR GB IT**

(56) References cited:
**GB-A-2 039 145**
**US-A-4 331 831**

**IBM TECHNICAL DISCLOSURE BULLETIN, vol.
26, no. 3b, August 1983, pages 1490-1492, W.C.
WARD: "Thermally enhanced plastic surface
encapsulated device"**

(73) Proprietor: **International Business Machines
Corporation
Old Orchard Road
Armonk, N.Y. 10504 (US)**

(72) Inventor: **Pashby, Richard P.
215 Sunset Hill
Williston, VT 05495 (US)**
Inventor: **Phelps, Douglas W., Jr.
21 Richardson Street
Burlington, VT 05401 (US)**
Inventor: **Samuelsen, Sigvart J.
111 Edgemoor Drive
Burlington, VT 05401 (US)**
Inventor: **Ward, William C.
28 Bilodeau Court
Burlington, VT 05401 (US)**

(74) Representative: **Louet Feisser, Arnold et al
Intellectual Property Department IBM Nederland
N.V. Watsonweg 2
NL-1423 ND Uithoorn (NL)**

Courier Press, Leamington Spa, England.

## Description

### Background of the Invention

#### 1. Field of the Invention

This invention relates to a packaged semiconductor chip having resistance to ingress of environmental contaminants, capability to make electrical contact to chip terminals remote from the chip periphery and further, to a package which contains an alpha barrier, conserves precious metal, is easily assembled and results in an encapsulated chip with enhanced electrical, mechanical and thermal performance.

#### 2. Description of the prior Art

Several techniques have been employed to position and affix leads to semiconductor chips prior to encapsulation of the chip in a protective coating.

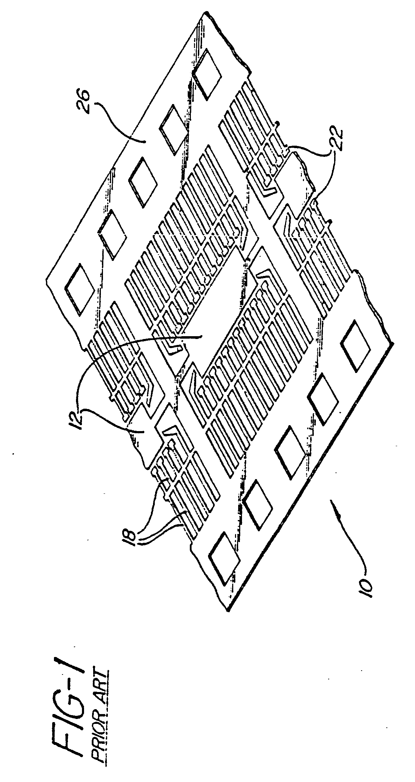

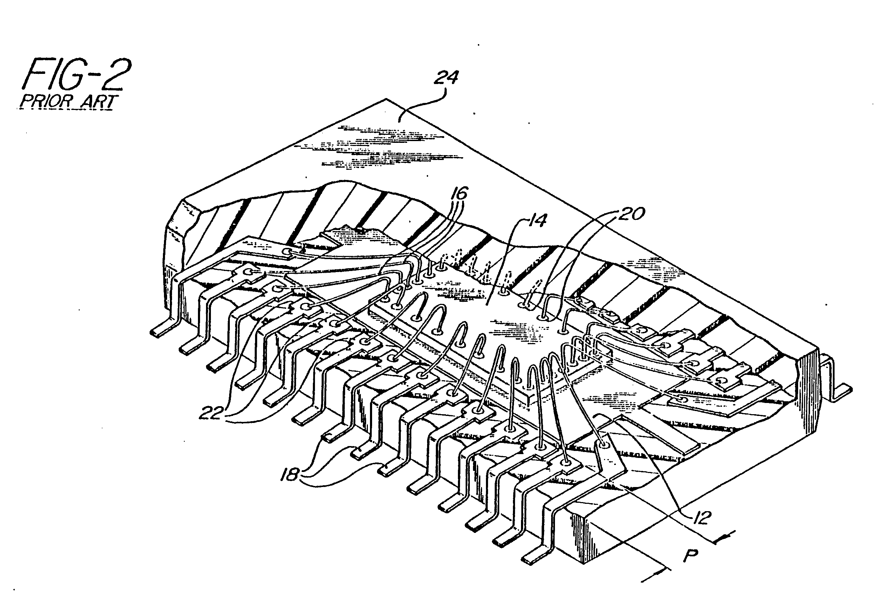

Current techniques employ a lead frame with a central tab to which the semiconductor chip is attached prior to encapsulation. As described herein at the beginning of the "Description of Preferred Embodiments" section with reference to Prior Art FIGS. 1 and 2, it is known in the prior art to connect terminal pads near the periphery of a semiconductor chip to corresponding fingers of a lead frame.

A common problem with the prior art semiconductor packages has been cracking along the mold parting line where the metal lead frame leads exit. Another problem has been the relatively short path for ingress of environmental contaminants along the metal leads from outside the package to the semiconductor chip. A still further problem has been an inability to reliably form conductors from the fingers of the metal lead frame to chip terminal pads located within the chip surface remote from the periphery of the chip. Moreover, the relatively long wire bond leads required to connect the metal leads to the chip terminals do not permit the crossing of wire bond leads for alternate I/O terminal assignment.

### Summary of the Invention

It is an object of this invention to provide a packaged semiconductor chip with improved mechanical, electrical and thermal performance.

Another object of the invention is to provide a packaged semiconductor chip with enhanced capability of connecting lead frame fingers to different chip terminals, thereby permitting the use of the same package with different semiconductor chips.

A supplementary object of the invention is to provide a packaged chip with an alpha barrier.

It is another object of the invention to provide a packaged semiconductor chip which conserves precious metal such as gold or silver.

It is a further object of the invention to provide a semiconductor chip in a package with a reduced size while maintaining relatively long lead frame path lengths thus limiting the ingress of corrosive environmental contaminants.

It is still another object of the invention to provide lead frame conductors which have a large portion of the path length encapsulated in the packaging material.

It is another object of the invention to provide a packaged semiconductor chip with package integrity.

It is yet another object of the present invention to provide a semiconductor package with enhanced package seal reliability.

These and other objects of the present invention, as claimed, are provided by a lead frame having a plurality of conductors. The lead frame is attached adhesively to a major surface of a semiconductor chip. As a preferred embodiment, a dielectric layer, typically an alpha barrier, is interposed between the lead frame and the chip and adhesively joined to both of them. As described later, a different adhesive may be used to attach the alpha barrier to the chip and to the lead frame. Wires connect terminals on the semiconductor chip and the lead frame conductors. The lead frame, alpha barrier, semiconductor chip, and wires which connect the semiconductor terminals to the lead frame conductors are encapsulated to form a semiconductor module.

The packaged semiconductor chip of the present invention preferably is comprised of a semiconductor chip which is adhesively attached to an alpha barrier and said alpha barrier is adhesively attached to the lead frame conductors. Wires run from the lead frame conductors to terminals on the semiconductor chip. The semiconductor, alpha barrier and conductors are embedded in an encapsulating material.

Preferably the lead frame conductors are brought in close proximity to terminals located along the center of the semiconductor chip and are electrically connected to the semiconductor chip by means of short wire bonds.

In another preferred embodiment a bus bar is provided. The bus bar serves both as a terminal strip and as a means for dissipating heat.

These and other objects, features and advantages of the invention will be apparent from the following more particular description of the preferred embodiments of the invention as illustrated in the accompanying drawings.

### Brief Description of the Drawings

FIG. 1 is a schematic representation of a prior art lead frame.

FIG. 2 is a schematic representation of a wire bonded encapsulated semiconductor chip employing the prior art lead frame of FIG. 1. Part of the encapsulation material has been broken away to expose the conductors, the support tab, the semiconductor chip, the chip terminals, and the wires used to connect the conductors to the chip terminals.

FIG. 3 is an exploded schematic representation for one embodiment of the present invention showing the spatial relation between the chip, the alpha barrier and the lead frame for one embodiment of the present invention.

FIG. 4 is a schematic representation of the said one embodiment of the present invention showing a wire bonded encapsulated semiconductor chip employing the lead frame of the present invention shown in FIG. 3. Part of the encapsulation material has been broken away to expose the conductors, the alpha barrier, the semiconductor chip, the chip terminals, and the wires used to connect the conductors and the chip terminals.

Description of the Preferred Embodiments.

A prior art lead frame and an encapsulated semiconductor chip are shown in FIGS. 1 and 2. The conductor lead frame 10 has a central support tab 12. The central support tab 12 supports and positions the semiconductor chip 14 for stability during subsequent wire bond and encapsulation operations. When using the conductor lead frame 10, shown in FIG. 1, long connecting wires 16, as shown in FIG. 2, connect the lead frame conductors 18 and chip terminals 20.

During encapsulation in packaging material 24 the conductors 18 and central support tab 12 are supported by the lead frame selvage 26 shown in FIG. 1. After the encapsulation the lead frame selvage 26 is removed. Because a minimum path length of about 0.5 mm to 1 mm is needed to assure sealing of the conductors in the encapsulating material the width of the semiconductor module must be 1—2 mm larger than the width of the chip 14.

Because the conductors 18 have a short path P within the encapsulating material 24 the conductors 18 terminate in anchors 22 to assure package integrity. The anchors 22 while providing support for the conductors 18 reduce the bonding area between the upper and lower segments of the encapsulating material. Because of the straight path from the edge of the package to the anchors 22, a short straight path is provided for ingress of corrosive environmental contaminants.

Prior to encapsulation, the semiconductor chip 14 is attached to the central support tab 12. This is frequently done by means of an epoxy resin glue. The long wires 16 which connect the conductors 18 to chip terminals 20 are typically 2.5 mm long. Since these long wires 16 are very fine, they have a relatively high impedance and thus reduce the electrical performance of the integrated circuits embedded in semiconductor chip 14 and limit the response times. The long wires 16 are required because the lead frame conductors 18 must be spaced away from the relatively large support tab 12 and chip 14.

The central support tab 12 and large portions of the conductors 18 are typically gold or silver plated. In part, because of the large area of the central support tab 12 which cannot economically be masked during plating, relatively large quantities of precious metal are required.

Furthermore, since the semiconductor chip 14 is isolated from the surroundings by the encapsulating material, heat generated by the chip is not readily dissipated which results in higher operating temperatures and a reduced semiconductor chip life.

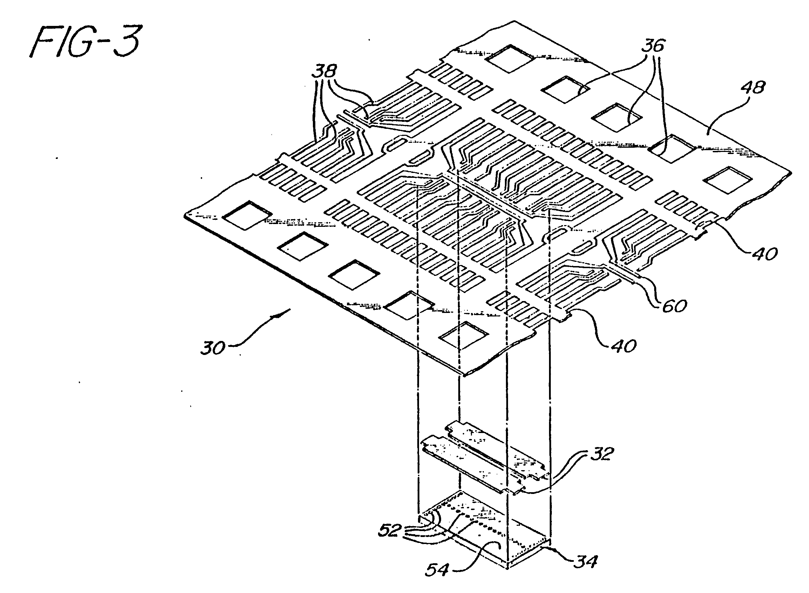

FIG. 3 is a schematic representation of an exploded view of a lead frame 30, an alpha barrier 32 and a semiconductor chip 34 showing the spatial relationship of these elements for one embodiment of the present invention.

The lead frame 30 is produced from metal sheet stock and is provided with indexing holes 36. The sheet stock is preferably a copper alloy. The interior portion of the lead frame 30 contains the lead frame conductors 38. The portion of the conductors 38 which extends over the semiconductor chip 34 is separated from semiconductor chip 34 by the alpha barrier 32.

The alpha barrier 32 is a polymeric film having a melting temperature in excess of 175°C and does not contain ionizable species such as halides and active metals including Na, K and P. Polyimide films can be used as alpha barriers as suggested in U.S. Patent 4,426,657 by Abiru et al. One such Polyimide film is Dupont Kapton (trademark).

The semiconductor chip 34 is attached to the lead frame conductors 38 by an adhesive layer not shown. A thin layer of adhesive is applied to the lead frame conductors or the top active surface. The top active surface is one of the major surfaces of the chip. To avoid any possibility of short circuit to the chip in spite of the fact that the chips are usually coated with a passivating/insulating material, it is preferable to use a dielectric interposer. It is preferred that the dielectric interposer be an alpha barrier 32 positioned between the conductors and the chip. The adhesive layer can then be applied to both surfaces of the alpha barrier 32 with different adhesive materials used for each surface.

To effectively serve as an alpha barrier while still allowing for effective heat transfer the alpha barrier 32 should be between about .037 and .05 mm thick.

The semiconductor chip 34 is attached to the alpha barrier 32 by a first adhesive layer. The first adhesive layer is selected from the group of epoxies, acrylics, silicones and polyimides with silicones being preferred since they minimize corrosion.

The second adhesive layer attaches the alpha barrier 32 to the conductors 38 and is selected from the group of epoxies, acrylics, silicones and polyimides. Preferably the second adhesive layer is selected from the group of epoxies and acrylics since these materials assure that the conductors 38 are fully bonded to the alpha barrier 32, thereby enhancing the thermal conductivity between the semiconductor chip 34 and the conductors 38, and mechanically locking the lead frame conductors 38 to the semiconductor chip 34.

Cross members 40 are provided between the conductors 38 of the lead frame 30 to impart rigidity to the lead frame 30 and to limit flow of the encapsulating material when the semiconductor chip 34, alpha barrier 32, and conductors 38 are encapsulated.

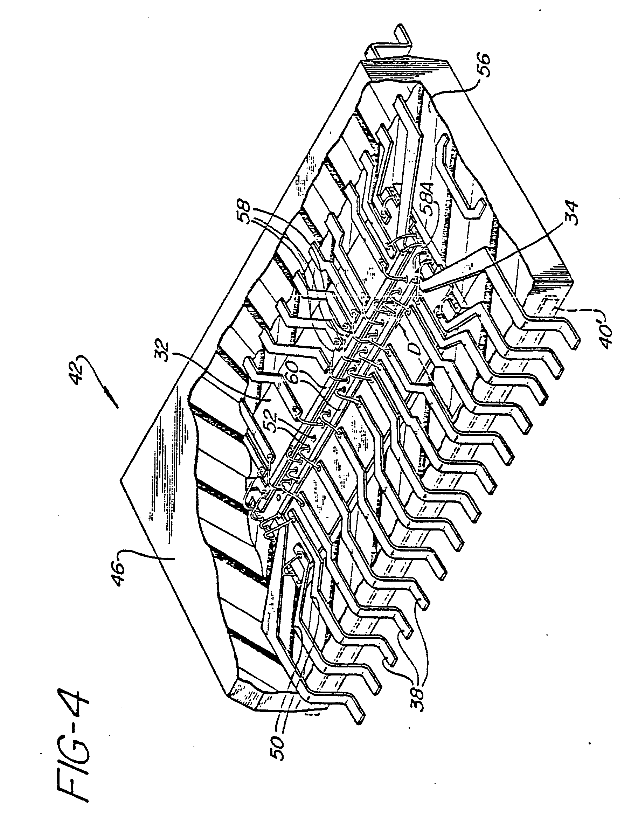

FIG. 4 shows a package 42 containing a semiconductor chip 34 in which part of the encapsulating material 46 has been removed. After encapsulation, the lead frame selvage 48 and the cross members 40 shown in FIG. 3 are removed. The conductors 38 which extend beyond the package 42 may be formed as required. The removed cross members are partially shown in phantom at 40' in FIG. 4.

The width of the conductors 38 should be minimized to ensure maximum top to bottom encapsulant sealing. The maximization of the encapsulant knitting at the part line 56 enhances crack resistance. A minimum path length of about 0.5 mm to 1 mm is needed to assure sealing of the conductors in the encapsulating material.

Encapsulant locking of the lead frame conductors 38 is achieved by providing the conductors 38 with anchors 22 as shown in FIG. 2, or sharp angles or kinks 50 as shown in FIG. 4. By providing the lead frame conductors with kinks, the package of the present invention permits the width of the semiconductor module to be reduced while maintaining superior mechanical characteristics, since the length of the leads within the packaging material is no longer limited by the distance between the chip and the edge of the package.

The conductors 38 should cover between 30% and 80% of the area of the surface of the semiconductor chip 34, and preferably a maximum percentage of the surface area. The conductors 38 should be positioned to avoid contact with terminal pads 52 on the semiconductor chip 34. This area maximization assures effective enhanced cooling of the semiconductor chip 34 and adequate bonding of the conductors 38 to the surface of semiconductor chip 34. The longer conductors 38, reaching over and adhering to the chip 34, result in a longer path (D) from the package exterior to the wire bonds, thus increasing resistance to ingress of environmental contaminants which could produce corrosion and premature failure.

Extraction of heat from the active layer 54, shown in FIG. 3, of the semiconductor chip 34 which contains the terminal pads 52, is more effective than extraction of heat from the back side of the semiconductor chip as is done with the packaged semiconductor chips of the prior art.

The terminal pads 52 are connected to the conductors 38 by wires 58. The configuration of the conductors 38 is preferably such that wires 58 are less than about .75 mm long. Minimizing the length of the wires 58 improves the electrical performance of the packaged semiconductor chip.

Coverage of between about 30% and 80% of the active surface 54 is preferred to assure adequate mechanical strength and to provide sufficient thermal conductivity between the conduc-

tors 38 and the semiconductor chip 34. In order to facilitate high coverage of the active surface 54 with conductors 38 and to maintain short wires 58 it is preferred that the terminal pads 52 be arranged in rows. Providing a row of centrally located terminal pads 52 reduces the impedance in the chip 34 by reducing conducting channel lengths within the chip. Electrical testing has shown this design to be substantially faster than the peripheral I/0 terminals counterpart. Furthermore, having the chip terminal pads 52 centrally located aids in bringing conductors 38 into close proximity to a number of chip terminal pads 52 and thus allows alternate wiring configurations since a terminal may be connected to a conductor which is not adjacent while still maintaining short wires. For example, wire 58A in FIG. 4 is shown connected to a nonadjacent finger of lead frame conductors 38. Such an alternative connection capability permits different chips to be packaged with the same electrical I/O specifications.

Having terminal pads 52 located in the central portion of the chip 34 has an additional advantage in that the terminal pads 52 are located over conducting channels which are not affected by alpha particles. Thus the alpha barrier 32 need not cover the central portion of the semiconductor chip 34 which simplifies assembly.

It is further preferred that bus bars 60 be employed which traverse the length of the chip 34 in close proximity to the central line. Multiple connections can be made from the bus bars 60 to the semiconductor chip 34 thereby minimizing the voltage drop through the chip 34. In addition, the bus bars, 60 are located over the active surface 54 of the chip known to dissipate over 50% of the heat, and thus the bus bars 60 facilitate cooling. Finite element analysis has shown the structure of FIG. 4 to be thermally superior by 5°C/watt to that depicted using the configuration shown in FIG. 2.

While the novel features of this invention have been described in terms of preferred embodiments and particular applications, it will be appreciated that various omissions and substitutions in form may be made by those skilled in the art without departing from the scope of the invention.

## Claims

1. An encapsulated semiconductor module (42) comprising:

a semiconductor chip (34) having terminals (52) thereon;

a plurality of lead frame conductors (38) passing through the encapsulating material (46); and wires (58) electrically connecting said conductors to said chip terminals;

characterized by:

said conductors (38) partly extending over, and being adhesively joined to, a substantial part of a major surface (54) of said chip.

2. The module of claim 1 further comprising:

a dielectric layer member (32) interposed between said lead frame conductors (38) and the major surface (54) of said chip (34), and further wherein said dielectric layer (32) is attached by a first adhesive layer to said semiconductor chip and is attached by a second adhesive layer to said plurality of conductors.

3. The module of claim 2 wherein said dielectric layer (32) is an alpha barrier, and is a film selected from the group of electronic grade polymeric materials.

4. The module of claim 3 wherein said alpha barrier is a polyimide film.

5. The module of a previous claim wherein said adhesive, or said first and said second adhesive layers are selected from the group of epoxies, acrylics, silicones and polyimides.

6. The module of a previous claim wherein one or more of said lead frame conductors (38) are provided with kinks (50) to mechanically lock said leads within said encapsulating material (46) and with respect to said chip (34).

7. The module of claim 2, 3 or 4 wherein said dielectric layer or alpha barrier (32) has a thickness of between about .037 and .05 mm.

8. The module of claim 2 or 5 wherein said first adhesive layer is selected from the group of silicones and said second adhesive layer is selected from the group of epoxies and acrylics.

9. The module of a previous claim wherein said terminals (52) are positioned to allow said conductors (38) to cover between about 30% and 80% of the surface (54) of said semiconductor chip (34).

10. The module of a previous claim wherein said wires (58) have average lengths less than approximately .75 mm.

11. The module of a previous claim wherein said terminals (52) are arranged in rows, one of which preferably is aligned centrally on said major surface (54).

12. The module of claim 11 further comprising one or more bus bars (60) attached to one or more lead frame conductors (38) and positioned in close proximity to one or more of said rows of terminals (52).

**Patentansprüche**

1. Halbleitermodul (42) in einen Gehäuse, mit
   einem mit Anschlüssen (52) versehenen Halbleiter-Chip (34).
   einer Vielzahl von Leitern (38) im Anschlußrahmen, welche durch das verkapselnde Material (46) verlaufen; und
   mit Drähten (58), welche die Leiter mit den Chip-Anschlüssen elektrisch verbinden,
   dadurch gekennzeichnet, daß
   die Leiter (38) sich zum Teil über einen wesentlichen Teil der Hauptoberfläche (54) des Chips erstrecken und an diesen angeklebt sind.

2. Modul nach Anspruch 1, mit
   einer dielektrischen Schicht (32), welche zwischen den Leitern (38) im Anschlußrahmen und der Hauptoberfläche (54) des Chips (34) angeordnet ist, dadurch gekennzeichnet, daß die dielektrische Schicht (32) mittels einer ersten Klebeschicht an den Halbleiter-Chip und mittels einer zweiten Klebeschicht an die Vielzahl von Leitern angebracht ist.

3. Modul nach Anspruch 2, dadurch gekennzeichnet, daß die dielektrische Schicht (32) eine Alpha-Barriere ist und aus der Gruppe der elektronischen polymeren Materialien ausgewählt ist.

4. Modul nach Anspruch 3, dadurch gekennzeichnet, daß die Alpha-Barriere eine Polyimid-Schicht ist.

5. Modul nach einem der vorhergehenden Ansprüche, dadurch gekennzeichnet, daß die Klebeschicht bzw. die erste und zweite Klebeschicht aus der Gruppe der Epoxidharze, der Acryle, der Silikone und der Polyamide ausgewählt sind.

6. Modul nach einem der vorhergehenden Ansprüche, dadurch gekennzeichnet, daß einer oder mehrere der Leiter (38) im Anschlußrahmen mit Knicken (50) zum mechanischen Verbinden der Leiter mit dem verkapselnden Material und bezüglich des Chips (34) versehen sind.

7. Modul nach Anspruch 2, 3 oder 4, dadurch gekennzeichnet, daß die dielektrische Schicht bzw. Alpha-Barriere (32) zwischen 0,037 und 0,05 mm dick ist.

8. Modul nach Anspruch 2 oder 5, dadurch gekennzeichnet, daß die erste Klebeschicht aus der Gruppe der Silikone und daß die zweite Klebeschnicht aus der Gruppe der Epoxidharze und der Acryle ausgewählt ist.

9. Modul nach einem der vorhergehenden Ansprüche, dadurch gekennzeichnet, daß die Anschlüsse (52) so angeordnet sind, daß die Leiter (38) zwischen ca. 30 und 80% der Oberfläche (54) des Halbleiter-Chips (34) bedecken.

10. Modul nach einem der vorhergehenden Ansprüche, dadurch gekennzeichnet, daß die Drähte (58) im Durchschnitt kürzer sind als ca. 0,75 mm.

11. Modul nach einem der vorhergehenden Ansprüche, dadurch gekennzeichnet, daß die Anschlüsse (52) in Reihen angeordnet sind, wobei eine davon vorzugsweise zentral auf der Oberfläche (54) ausgerichtet ist.

12. Modul nach Anspruch 11, dadurch gekennzeichnet, daß eine oder mehrere Sammelschienen (60) an einem oder mehreren Leitern (38) im Anschlußrahmen angebracht sind und sich in der Nähe zu einer oder mehreren der Anschlußreihen befinden.

**Revendications**

1. Module semiconducteur encapsulé (42) comprenant:
   une puce (34) de semiconducteur sur laquelle se trouvent des bornes (52);
   une pluralité de conducteurs (38) de cadre de montage passant à travers la matière d'encapsulage (46); et
   des fils (58) reliant électriquement lesdits conducteurs auxdites bornes de la puce;
   caractérisé en ce que:
   lesdits conducteurs (38) s'étendent partielle-

ment sur une partie considérable d'une grande surface (54) de ladite puce, et sont joints par collage à celle-ci.

2. Module selon la revendication 1, comprenant en outre:

un élément (32) formant couche de diélectrique intercalé entre lesdits conducteurs (38) de cadre de montage et la grande surface (54) de ladite puce (34), et en outre dans lequel ladite couche de diélectrique (32) est fixée par une première couche de colle à ladite puce de semiconducteur et est fixée par une seconde couche de colle à ladite pluralité de conducteurs.

3. Module selon la revendication 2, dans lequel ladite couche de diélectrique (32) est une couche d'arrêt alpha et est une pellicule en matière choisie parmi le groupe des polymères de qualité électronique.

4. Module selon la revendication 3, dans lequel ladite couche d'arrêt alpha est une pellicule de polyimide.

5. Module selon l'une quelconque des revendications précédentes, dans lequel ladite colle ou lesdites première et seconde couches de colle sont en matière choisie dans le groupe des résines époxydes, des résines acryliques, des silicones et des polyimides.

6. Module selon l'une quelconque des revendications précédentes, dans lequel un ou plusieurs desdits conducteurs (38) de cadre de montage sont pourvus de coudes (50) pour bloquer mécaniquement lesdits conducteurs à l'intérieur de ladite matière d'encapsulage (46) et par rapport à ladite puce (34).

7. Module selon la revendication 2, 3 ou 4, dans lequel ladite couche de diélectrique ou couche d'arrêt alpha (32) a une épaisseur comprise entre environ 0,037 et 0,05 mm.

8. Module selon la revendication 2 ou 5, dans lequel ladite première couche de colle est en matière choisie dans le groupe des silicones et ladite seconde couche de colle est en matière choisie dans le groupe des résines époxydes et des résines acryliques.

9. Module selon l'une quelconque des revendications précédentes, dans lequel lesdites bornes (52) sont placées pour permettre auxdits conducteurs (38) de couvrir environ entre 30% et 80% de la surface (54) de ladite puce (34) de semiconducteur.

10. Module selon l'une quelconque des revendications précédentes, dans lequel lesdits fils (58) ont une longueur moyenne inférieure à environ 0,75 mm.

11. Module selon l'une quelconque des revendications précédentes, dans lequel lesdites bornes (52) sont disposées en rangées dont l'une est de préférence alignée centralement sur ladite grande surface (54).

12. Module selon la revendication 11, comportant en outre une ou plusieurs barres omnibus (60) fixées à un ou plusieurs conducteurs (38) de cadre de montage et disposées tout près d'une ou plusieurs desdites rangées de bornes (52).

FIG-1
PRIOR ART

FIG-2
PRIOR ART

FIG-3

EP 0 198 194 B1

FIG-4

EP 0 198 194 B1